# EUROPEAN PATENT SPECIFICATION

(11) **EP 4 518 308 B1**
(45) Date of publication and mention of the grant of the patent: **19.08.2026**
(21) Application number: 23819945.9
(22) Date of filing: 30.01.2023
(51) Int. Cl.: B60B 33/00, F16M 11/42, F16M 11/22, H04N 5/64

(54) **DISPLAY DEVICE**
ANZEIGEVORRICHTUNG
DISPOSITIF D'AFFICHAGE

(30) Priority: 08.06.2022 KR 20220069737
(43) Date of publication of application: 05.03.2025
(73) Proprietor: LG Electronics Inc., Yeongdeungpo-gu Seoul 07336 (KR)
(72) Inventor: LEE, Kangyeung, Seoul 06772 (KR); KIM, Sanghoon, Seoul 06772 (KR); JUNG, Hyunjin, Seoul 06772 (KR)
(74) Representative: Vossius & Partner Patentanwälte Rechtsanwälte mbB
(86) International application number: PCT/KR2023/001328
(87) International publication number: WO 2023/239006

(56) References cited:
- CN-B- 108 799 700
- JP-B2- 6 372 470
- KR-A- 20060 133 860
- KR-B1- 101 671 719
- KR-B1- 101 756 464
- US-B1- 8 721 199

## Description

### [Technical Field]

Embodiments of the present disclosure relate to a display device in which the area (size) of a display unit can be freely adjusted.

### [Background Art]

With growth of information society, demand for various display devices has increased. In order to satisfy such demand, in recent years, a liquid crystal display (LCD), a field emission display (FED), a plasma display panel (PDP), and an electroluminescent device have been developed as display devices.

A liquid crystal panel of the liquid crystal display includes a liquid crystal layer and a TFT substrate and a color filter substrate opposite each other in the state in which the liquid crystal layer is interposed therebetween, wherein a picture is displayed using light provided from a backlight unit.

An active matrix type organic light-emitting display has come onto the market as an example of the electroluminescent device. Since the organic light-emitting display is self-emissive, the organic light-emitting display has no backlight, compared to the liquid crystal display, and has merits in terms of response time and viewing angle, and therefore the organic light-emitting display has attracted attention as a next-generation display.

Recently, materials such as OLEDs, which are self-illuminating without a backlighting structure on the backside, have allowed for the realization of bendable display modules, enabling the realization of curved display devices.

As the size of the display device increases, the design of the display device may determine the atmosphere of a room where the display device is installed. In particular, in a situation where the display device is not used, a dark large screen of the display device causes the room atmosphere to become dark. In order to hide the dark screen of the display device, a rollable display device or a display device integrated with a storage unit covering a front surface of the display device has recently been developed and released.

However, in the case of a rollable display device, there is a problem that the durability of a flexible display and the number of constituent components of a driving unit for deformation of the display unit increase, and high-quality components are used so that the unit cost of the display device increases. In addition, a display device integrated with the storage unit has a problem that a space required for covering the front surface of this display device is large and it is difficult to implement a large screen.

### [Disclosure]

### [Technical Problem]

An object of the present disclosure is to provide a display device that minimizes the size of an exposed screen of a display unit when the display device is not used, and allows a display screen of the display unit to be exposed outside when the display device is used so that a user can view a large screen of the display device.

Another object of the present disclosure is to provide a display device in which a moving grille covering a front surface of the display device without using a separate stand furniture constitutes a lower support structure, thereby allowing the display unit to be located at an optimal position when a user views the display unit.

Another object of the present disclosure is to provide a display device configured such that, even when a gap between the moving grilles is widened, internal components of the display device are not exposed outside and heat can be discharged between the moving grilles, thereby resolving the problem of heat generation.

### [Technical Solutions]

In accordance with an aspect of the present disclosure, a movable stand base may include: a base case; a wheel housing inserted from a lower portion of the base case; a wheel module placed in the wheel housing; a rotation plate rotatably coupled to the base case; and a brake ring that is located in the wheel housing, moves in a vertical direction while rotating during rotation of the rotation plate, wherein, when the brake ring moves downward, the brake ring restricts rotation of the wheel by contacting a wheel of the wheel module
The wheel housing may be formed in a cylindrical shape. The wheel module may include a caster bracket rotatably coupled to a center of an upper portion of the wheel housing; and a wheel coupled to the caster bracket to rotate around a second shaft perpendicular to a first shaft located at a center of rotation of the caster bracket.

The brake ring may include: a frictional surface formed in a ring shape at a lower end of the stand base and including an inclined surface.

The movable stand base may further include: a guide slot extending horizontally on a side surface of the wheel housing; and a guide protrusion protruding from an outer circumference of the brake ring and inserted into the guide slot, wherein the guide slot includes a slope obliquely inclined in a vertical direction; and when the brake ring rotates, a position of the brake ring is changed vertically as the guide protrusion moves along the guide slot.

The guide slot may be implemented as a plurality of guide slots, and the guide protrusion may be implemented as a plurality of guide slots. The rotation plate may further include a vertical slot into which one of the plurality of guide protrusions is inserted so that the vertical slot extends in a vertical direction, and when the rotation plate rotates, a position of the guide protrusion on the vertical slot is changed.

The movable stand base may further include: an insertion slot extending downward from an upper end of the guide slot.

The movable stand base may further include: a lever extending from the rotation plate and exposed on a side surface of the base case.

In accordance with another aspect of the present disclosure, a movable stand base may include: a base case configured to include an opening at a bottom surface thereof; a wheel housing inserted from a lower portion of the base case; a wheel module accommodated in the wheel housing; an inclined portion formed around the opening; and a rotation plate rotatably coupled to the base case while overlapping the opening of the base case and the inclined portion. When the rotation plate rotates, the rotation plate moves along the inclined portion and a height of the rotation plate protruding downward from the opening is changed.

The movable stand base may further include: a hole formed at a position corresponding to the inclined portion of the rotation plate; and a groove located at a lower portion of an upper end of the inclined portion. The inclined portion is exposed through the hole, and when an end of the hole is fastened to the groove, the rotation plate protrudes downward from the opening; and when the rotation plate overlaps the inclined portion, the rotation plate is inserted into the opening.

In accordance with another aspect of the present disclosure, a display device may include: a main body; a stand pillar configured to extend downward from the main body; and a stand base located at a lower portion of the stand pillar and including a plurality of wheels. The stand base includes: a base case; a wheel housing inserted from a lower portion of the base case; a wheel module placed in the wheel housing; a rotation plate rotatably coupled to the base case; and a brake ring that is located in the wheel housing, moves in a vertical direction while rotating during rotation of the rotation plate. When the brake ring moves downward, the brake ring restricts rotation of the wheel by contacting a wheel of the wheel module.

The display device may further include: a guide slot extending horizontally on a side surface of the wheel housing; and a guide protrusion protruding from an outer circumference of the brake ring and inserted into the guide slot. The guide slot includes a slope obliquely inclined in a vertical direction; and when the brake ring rotates, a position of the brake ring is changed vertically as the guide protrusion moves along the guide slot.

### [Advantageous Effects]

As is apparent from the above description, the stand base according to the embodiments of the present disclosure is easy to move by using wheels, and rotation of the wheels can be limited, thereby increasing stability of the stand base when the stand base is placed.

The stand base can be easily fixed regardless of the direction of the wheels.

Effects obtainable from the present embodiments are not limited by the above mentioned effects, and other unmentioned effects can be clearly understood from the above description by those having ordinary skill in the technical field to which the present disclosure pertains.

### [Description of Drawings]

FIG. 1 is a block diagram illustrating internal components of a display device according to the present disclosure.
FIG. 2 is a front perspective view illustrating one example of a display device according to the present disclosure.
FIG. 3 is an exploded perspective view illustrating one example of a stand base according to the present disclosure.
FIG. 4 is an exploded view illustrating a process of coupling a wheel module and a brake ring to a wheel housing according to an example of the stand base of the present disclosure.
FIG. 5 is a perspective view illustrating a lower base case and a rotation plate according to an example of the stand base of the present disclosure.
FIG. 6 is a diagram illustrating the movement of a brake ring in a wheel housing according to an example of the stand base of the present disclosure.
FIG. 7 is a cross-sectional view illustrating a wheel module portion according to an example of the stand base of the present disclosure.
FIG. 8 is an exploded perspective view illustrating another example of the stand base of the present disclosure.
FIG. 9 is a diagram illustrating a locked state of the stand base according to the embodiment of FIG. 8.
FIG. 10 is a diagram illustrating an unlocked state of the stand base according to the embodiment of FIG. 8.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Meanwhile, an image display device 100 described in this specification is, for example, an intelligent image display device 100 having a computer supporting function in addition to a broadcast reception function, wherein an Internet function may be added while the broadcast reception function is devotedly performed, whereby an interface that is more conveniently used, such as a handwriting type input device, a touchscreen, or a space remote control, may be provided. In addition, the image display device may be connected to the Internet or a computer through support of a wired or wireless Internet function, whereby various functions, such as e-mail, web browsing, banking, or gaming, may be executed. For such various functions, a standardized general-purpose OS may be used.

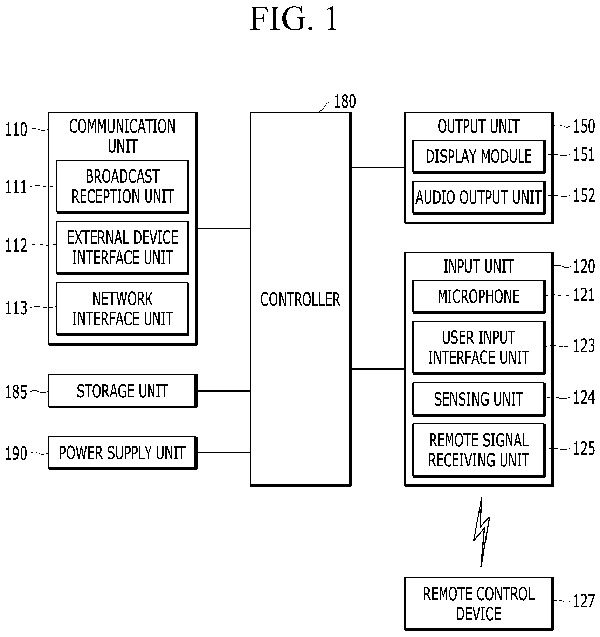

FIG. 1 is a block diagram illustrating components of a display device 100.

The display device 100 may include a communication unit 110, an input unit 120, a sensing unit 124, an output unit 150, a controller 180, a storage unit 185, and a power supply unit 190. The configuration shown in FIG. 1 may include only some of the components, and one configuration may perform two functions.

The communication unit 110 may include a broadcast reception unit 111 including a tuner unit and a demodulator. The tuner unit of the broadcast reception unit 111 may select a broadcast signal corresponding to a channel selected by a user or any one of all pre-stored channels, among broadcast signals received through an antenna (not shown) or a cable (not shown). The tuner unit 111 may convert the selected broadcast signal into an intermediate frequency signal or a baseband video or audio signal.

Meanwhile, the tuner unit may sequentially select broadcast signals of all broadcast channels stored through a channel memory function, among received broadcast signals, and may convert each of the selected broadcast signals into an intermediate frequency signal or a baseband video or audio signal

The demodulation unit of the broadcast reception unit 111 may receive the digital IF (DIF) signal converted by the tuner unit, and may perform demodulation. After performing demodulation and channel decryption, the demodulation unit may output a stream signal (TS). At this time, the stream signal may be a multiplexed image, audio, or data signal.

The stream signal output from the demodulation unit may be input to the controller 180. After performing demultiplexing and image/audio signal processing, the controller 180 may output an image through the display module 151, and may output audio through the audio output unit 152.

An external device interface unit 112 may connect an external device to the display device 100 to receive an image signal, an audio signal, and a control signal from the external device. The interface unit 112 may be connected by wire/wireless to external devices such as a Digital Versatile Disk (DVD), a Blu-ray, a game device, a camera, a camcorder, a computer (laptop), and the like.

The external device interface unit 112 transmits video, audio, or data signals inputted externally to the controller 180 of the display device 100 through the connected external device. In addition, the video, audio, or data signals processed by the controller 180 may be outputted to the connected external device.

The external device interface unit 112 may include a wired type and a wireless type. The wired type includes a physical terminal provided to the display device 100, and the wireless type may be connected to an external device through an antenna that receives a wireless signal.

The wired type may include a USB terminal, a Composite Video Banking Sync (CVBS) terminal, a component terminal, an S-video terminal (analog), a Digital Visual Interface (DVI) terminal, a High Definition Multimedia Interface (HDMI) terminal, an RGB terminal, a D-SUB terminal, and so on.

The wireless type may perform short-range wireless communication with other electronic devices located nearby. The display device 100 may be connected to other electronic devices via networks according to communication standards such as Bluetooth, Radio Frequency Identification (RFID), Infrared Data Association (IrDA), Ultra Wideband (UWB), ZigBee, Digital Living Network Alliance (DLNA), etc.

The network interface unit 113 may access a prescribed web page through a connected network or another network linked to the connected network. That is, the network interface unit 113 may transmit and receive data with a corresponding server by accessing the prescribed web page through the network. In addition, the network interface unit 113 may receive contents or data provided by a content provider or a network operator.

That is, contents such as movies, advertisements, games, VODs, and broadcast signals provided from content providers or network providers and information related to such contents may be received through the network. In addition, update information and update files of firmware provided by the network operator may be received. In addition, data may be transmitted to the Internet or content provider or network operator.

In addition, the network interface unit 113 may select a desired application from applications opened to the public and receive the selected application through the network.

According to an embodiment, when a game application is executed in the display device, the network interface unit 113 may transmit or receive prescribed data to or from a user terminal connected to the display device via the network. Also, prescribed data may be transmitted or received with a server that stores game scores

The input unit 120 may include a microphone 121 that collects sound, a user input unit 123 that detects a user's command, a sensor unit that senses a state and surrounding state of the display device, and a remote signal reception unit 125 that receives a signal of a remote controller 127.

The microphone 121 may recognize a user's voice or surrounding sound, and in particular, receive a user's voice and process it as electrical audio data. Various noise cancellation algorithms for removing noise generated in the process of receiving an external audio signal may be implemented in the microphone 121.

The microphone 121 may simply collect user's voice, convert the collected voice into audio data, and store it in the storage unit 185 or transmit it to the external device via the communication unit110, and may also perform a function as the user input unit 123 in a manner of analyzing the audio data and recognizing it as a user command.

In addition to the main body of the display device 100, the microphone 121 may be mounted on the remote controller 127, which will be described later, and the corresponding audio data may be forwarded to the controller 180 through the remote signal reception unit 125.

The user input unit 123 is a device to which a user inputs a control command for controlling the display device. The user input unit 123 may include a keypad, a button, a touch pad, a touch screen, etc.

When the user input unit 123 includes a hard key button, a user may input a command related to the display device 100 through a push operation of the hard key button. When the user input unit 123 is provided with a touchscreen, the user may input a command related to display device 100 to remote controller 127 by touching the soft key of the touchscreen.

In addition, the user input unit 123 may include various types of input means that the user can operate, such as a scroll key, a jog key, etc., and the present embodiment does not limit the scope of the right of the present disclosure.

Recently, as the size of a bezel of the display device 100 decreases, the display device 100 tends to minimize the user input unit 123 of the physical button type exposed externally. Instead, a minimum physical button is located on a rear side or a lateral side, and a user input may be received from a touchpad or the remote controller 127 through a remote signal reception unit 125 that will be described later.

The remote signal reception unit 125 may input a command related to the display device 100 through the remote controller 127 having the user input unit 123. The remote signal reception unit 125 is a sort of the user input unit 123 and may belong to a wireless communication unit because it receives signals from the remote controller 127 according to various communication methods such as Radio Frequency (RF) communication method, Infrared (IR) communication method, etc.

The sensing unit 124 refers to a device that detects a change in the display device 100 or an external change. For example, the sensing unit 124 may include at least one of a proximity sensor, an illumination sensor, a touch sensor, an Infrared (IR) sensor, an ultrasonic sensor, an optical sensor (e.g., a camera), a voice sensor (e.g., a microphone), a battery gauge, an environment sensor (e.g., a hygrometer, a thermometer, etc.), and the like.

Recently, a display device 100 that can move or change a direction of a display has emerged, and a gyro sensor, an acceleration sensor and the like may be provided to detect a posture of the display device.

Based on the information collected by the sensing unit 124, the controller 180 may check the state of the display device 100 and notify a user of a problem when the problem occurs or adjust it by itself, thereby controlling the display device 100 to maintain a best state.

In addition, the content, image quality, and size of an image provided to the display module 151 may be controlled differently depending on a viewer, a surrounding illumination and the like sensed by the sensing unit 124, thereby providing an optimal viewing environment. As smart TVs advance, functions mounted on the display device increase, and the sensing unit 124 is also increasing correspondingly.

The output unit 150 is a device that provides visual and auditory information to a user through the display device, and may include the display module 151 and the audio output unit 152.

The display module 151 may convert an image signal, a data signal, an OSD signal, and a control signal processed by the controller 180 or an image signal, a data signal, and a control signal received from the interface unit to generate a driving signal. The display module 151 may include a display panel having a plurality of pixels.

Each of the plurality of pixels in the display panel may include RGB subpixels. Alternatively, each of the plurality of pixels in the display panel may include RGBW subpixels. The display module 151 may convert an image signal, a data signal, an OSD signal, and a control signal processed by the controller 180 to generate a driving signal for the plurality of pixels.

A plasma display panel (PDP), a liquid crystal display (LCD), an organic light-emitting diode (OLED), or a flexible display may be used as the display module 151, and a 3D display may also be used. The 3D display 130 may be classified as a non-glasses type display or a glasses type display.

The display device 100 includes a display module 151, which occupies a major portion of the front surface thereof, and a case configured to cover the rear surface and the side surface of the display module 151, the case being configured to package the display module 151.

In recent years, the display device 100 has used a flexible display module 150, such as light-emitting diodes (LED) or organic light-emitting diodes (OLED), in order to implement a curved screen.

Light is supplied to an LCD, which was mainly used conventionally, through a backlight unit, since the LCD is not self-emissive. The backlight unit is a device that supplies light emitted from a light source to a liquid crystal uniformly located in front thereof. As the backlight unit has been gradually thinned, a thin LCD has been implemented. However, it is difficult to implement the backlight unit using a flexible material. If the backlight unit is curved, it is difficult to supply uniform light to the liquid crystal, whereby the brightness of a screen is changed.

In contrast, the LED or the OLED may be implemented so as to be curved, since an element constituting each pixel is self-emissive, and therefore no backlight unit is used. In addition, since each element is self-emissive, the brightness of the element is not affected even though the positional relationship between adjacent elements is changed, and therefore it is possible to implement a curved display module 150 using the LED or the OLED.

An organic light-emitting diode (OLED) panel appeared in earnest in mid 2010 and has rapidly replaced the LCD in the small- or medium-sized display market. The OLED is a display manufactured using a self-emissive phenomenon of an organic compound in which the organic compound emits light when current flows in the organic compound. The response time of the OLED is shorter than the response time of the LCD, and therefore afterimages hardly appear when video is implemented.

The OLED is an emissive display product that uses three fluorescent organic compounds having a self-emissive function, such as red, green, and blue fluorescent organic compounds and that uses a phenomenon in which electrons injected at a negative electrode and a positive electrode and particles having positive charges are combined in the organic compounds to emit light, and therefore a backlight unit, which deteriorates color, is not needed.

A light-emitting diode (LED) panel is based on technology of using one LED element as one pixel. Since it is possible to reduce the size of the LED element, compared to a conventional device, it is possible to implement a curved display module 150. The conventional device, which is called an LED TV, uses the LED as a light source of a backlight unit that supplies light to the LCD, and therefore the LED does not constitute a screen.

The display module includes a display panel and a coupling magnet, a first power supply unit, and a first signal module located at a rear surface of the display panel. The display panel may include a plurality of pixels R, G, and B. The plurality of pixels R, G, and B may be formed at intersections between a plurality of data lines and a plurality of gate lines. The plurality of pixels R, G, and B may be disposed or arranged in a matrix form.

For example, the plurality of pixels R, G, and B may include a red subpixel 'R', a green subpixel 'G', and a blue subpixel 'B'. The plurality of pixels R, G, and B may include a white subpixel 'W'.

The side of the display module 150 on which a picture is displayed may be referred to as a front side or a front surface. When the display module 150 displays the picture, the side of the display module 150 from which the picture cannot be viewed may be referred to as a rear side or a rear surface. Meanwhile, the display module 150 may be constituted by a touchscreen, whereby an input device may also be used in addition to an output device.

The audio output unit 152 receives an audio signal processed by the controller 180 and outputs the same as audio.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

The controller 180 may demultiplex a stream input through the tuner unit, the demodulation unit the external device interface unit 112, or the network interface unit 113, or may process demultiplexed signals to generate and output a signal for image or audio output.

An image signal processed by the controller 180 may be input to the display module 151, which may display an image corresponding to the image signal. In addition, the image signal processed by the controller 180 may be input to an external output device through the external device interface unit 112.

An audio signal processed by the controller 180 may be output through the audio output unit 152. In addition, the audio signal processed by the controller 180 may be input to an external output device through the external device interface unit 112.

Further, the controller 180 may control the overall operation of the display device 100. For example, the controller 180 may control the tuner unit such that a broadcast corresponding to a channel selected by a user or a pre-stored channel is tuned.

In addition, the controller 180 may control the display device 100 according to a user command input through the user input interface unit or an internal program. Meanwhile, the controller 180 may control the display module 151 to display an image. At this time, the image displayed on the display module 151 may be a still image or video, or may be a 2D image or a 3D image.

Meanwhile, the controller 180 may perform control such that a predetermined 2D object is displayed in an image displayed on the display module 151. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

Meanwhile, the display device 100 may further include a photographing unit (not shown). The photographing unit may photograph a user. The photographing unit may be implemented by one camera; however, the present disclosure is not limited thereto. The photographing unit may be implemented by a plurality of cameras. Meanwhile, the photographing unit may be embedded in the display device 100 above the display module 151, or may be separately disposed. Image information photographed by the photographing unit may be input to the controller 180.

The controller 180 may recognize the location of a user based on an image captured by the photographing unit. For example, the controller 180 may recognize the distance between the user and the display device 100 (z-axis coordinate). Further, the controller 180 may recognize an x-axis coordinate and a y-axis coordinate in the display module 151 corresponding to the location of the user.

The controller 180 may sense user gesture based on the image captured by the photographing unit, a signal sensed by the sensor unit, or a combination thereof.

The storage unit 185 may store programs for signal processing and control in the controller 180, and may store a processed image, audio, or data signal. For example, the storage unit 185 may store application programs designed to execute various tasks that can be processed by the controller 180, and may selectively provide some of the stored application programs in response to request of the controller 180.

Programs stored in the storage unit 185 are not particularly restricted as long as the programs can be executed by the controller 180. The storage unit 185 may temporarily store an image, audio, or data signal received from an external device through the external device interface unit 171. The storage unit 185 may store information about a predetermined broadcast channel through a channel memory function, such as a channel map.

FIG. 1 shows an embodiment in which the storage unit 185 and the controller 180 are separately provided; however, the present disclosure is not limited thereto. The storage unit 185 may be included in the controller 180.

The storage unit 185 may include at least one of a volatile memory (e.g. DRAM, SRAM, or SDRAM), a nonvolatile memory (e.g. flash memory), a hard disk drive (HDD), and a solid-state drive (SSD).

The power supply unit 190 may supply power to the components of the display device 100. In particular, the power supply unit may supply power to the controller 180, which may be implemented in the form of a system on chip (SOC), the display module 150 for image display, and the audio output unit 160 for audio output.

Specifically, the power supply unit 190 may include an AC/DC converter (not shown) configured to convert AC power into DC power and a DC/DC converter (not shown) configured to convert the level of the DC power.

Meanwhile, the power supply unit 190 serves to distribute power supplied from the outside to the respective components of the display device. The power supply unit 190 may be directly connected to an external power supply in order to supply AC power, or may include a battery so as to be used by charging.

In the former case, a cable is used, and the power supply unit is difficult to move or the movement range of the power supply unit is limited. In the latter case, the power supply unit is free to move, but the weight of the power supply unit is increased in proportion to the weight of the battery, the volume of the power supply unit is increased, and, for charging, the power supply unit must be directly connected to a power cable or must be coupled to a charging holder (not shown) that supplies power for a predetermined time.

The charging holder may be connected to the display device through a terminal exposed to the outside, or the battery mounted in the power supply unit may be charged in a wireless manner when the power supply unit approaches the charging holder.

Meanwhile, the block diagram of the display device 100 shown in FIG. 1 is for an embodiment of the present disclosure, and elements of the block diagram may be integrated, added, or omitted depending on specifications of an actually implemented display device 100.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

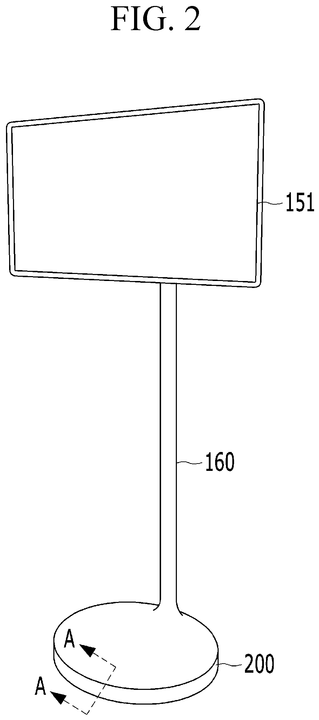

FIG. 2 is a front perspective view illustrating one example of the display device 100 according to the present disclosure. Referring to FIG. 2, the display device 100 according to the present disclosure has a stand that is placed on the floor. The display device 100 may include a stand base 200 placed on the floor, and a stand pillar 160 that extends vertically from the stand base 200 and is connected to a display body 100' in which a display unit 151 is located at the front surface of the display body 100'.

In order to adjust the height of the display unit 151 according to the height of the user's eye, the length of the stand pillar 160 may be changed. For example, when the user who is sitting on a desk views the display unit, when the user who is sitting on a sofa views the display unit, or when the user who is lying on a bed views the display unit, the height of the user's eyes viewing the display unit is changed, so that the height of the stand pillar 160 can be easily adjusted in response to the changing height of the user's eyes.

In addition, the stand pillar 160 may be located at one side of the stand base 200 so that the display device 100 of the present disclosure can be used while closely attached to a desk or bed.

The stand base 200 may further include a weight plate 225 that has a predetermined size to support the stand pillar 160 located at the top and the display body 100' so that they do not fall over. The weight plate 225 may be used to support the inside of the stand base 200.

In addition, a wheel 253 may be provided on the bottom of the stand base 200 so that the user can easily move the display device 100 to a study, living room, bedroom, etc. However, if the stand base 200 moves unintentionally by the wheel 253, the stability of the stand base 200 decreases, so that the display device 100 needs to be fixed so that the display device 100 does not move during use.

Accordingly, the stand base 200 according to the present disclosure has a brake structure to prevent movement of the wheel 253 located at the bottom of the stand base 200 so that, even when the stand base 200 does not move, the stability of the stand base 200 can be secured.

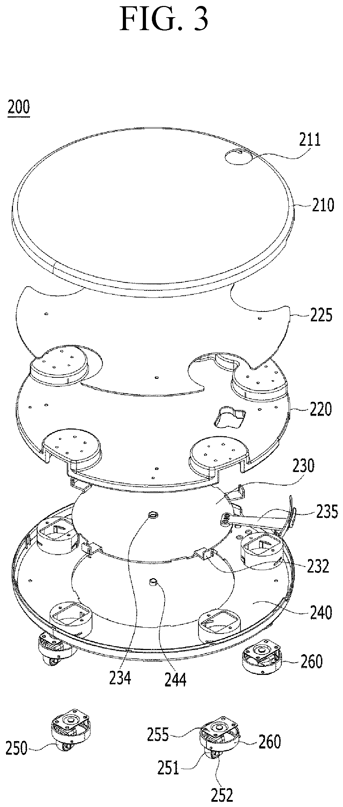

FIG. 3 is an exploded perspective view illustrating one example of the stand base 200 according to the present disclosure. Referring to FIG. 3, the stand base 200 may include base cases (210, 240), a wheel module 250, a brake ring 260, a rotation plate 230, and a middle frame 220.

The stand base 200 has a disc-shaped appearance, but is not limited thereto and may have a shape such as a rectangle, pentagon, hexagon, or the like. The base cases (210, 240) may include an upper base case 210 and a lower base case 240. A rotation plate 230 and a middle frame 220 may be disposed between the upper base case 210 and the lower base case 240.

A hole 211 into which the stand pillar 160 is inserted may be formed at one side of the upper base case 210, and a power cable connected to the main body 100' through the stand pillar 160 may extend from the side of the stand base 200 and may be connected to an external power source.

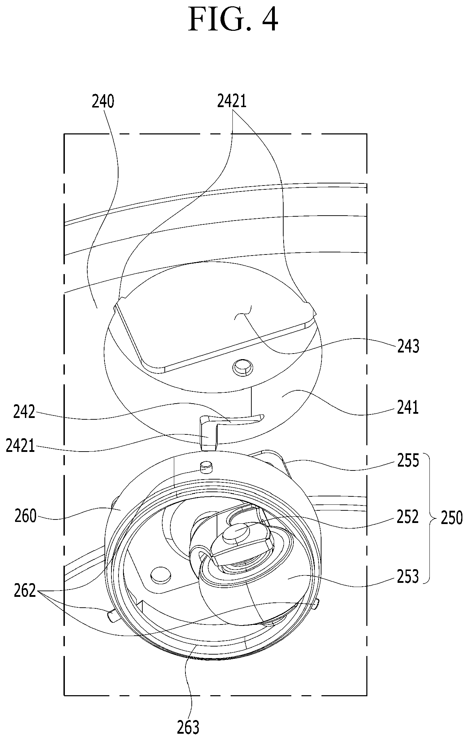

FIG. 4 is an exploded view illustrating a process of coupling the wheel module 250 and the brake ring 260 to the wheel housing 241 according to an example of the stand base 200 of the present disclosure. The lower base case 240 may include a plurality of wheel housings 241 into which a plurality of wheel modules 250 is inserted.

Each of the wheel housings 241 may have a cylindrical shape that is inserted from the bottom surface of the lower base case 240. The wheel module 250 may be directly coupled to the lower base case 240. Alternatively, as illustrated in FIG. 3, the upper portion of the wheel housing 241 may be opened (243) and the wheel module 250 may be coupled to a middle frame 220.

The middle frame 220 may have a shape that covers the upper portion of the wheel housing 241 corresponding to the shape of the wheel housing 241 protruding from the lower base case 240. The middle frame 220 may cover the upper opening 243 of the wheel housing 241, may form a portion of the upper portion of the wheel housing 241, and the wheel module 250 may be coupled to the middle frame 220.

The middle frame 220 may be configured to have a material that has weight or to have a large thickness so that the center of gravity of the display device 100 is located in the downward direction.

However, as shown in FIG. 3, since manufacturing costs and precision are reduced when a metallic material forms irregularities, the middle frame 220 may be configured as an injection molded product, but a weight plate 225 formed of a separate heavy material may be added to increase the weight of the stand base 200. The weight plate 225 has a plate shape while located at a portion other than the protruding portion of the wheel housing 241, may be easily manufactured, and may minimize an increase in the thickness of the stand base 200.

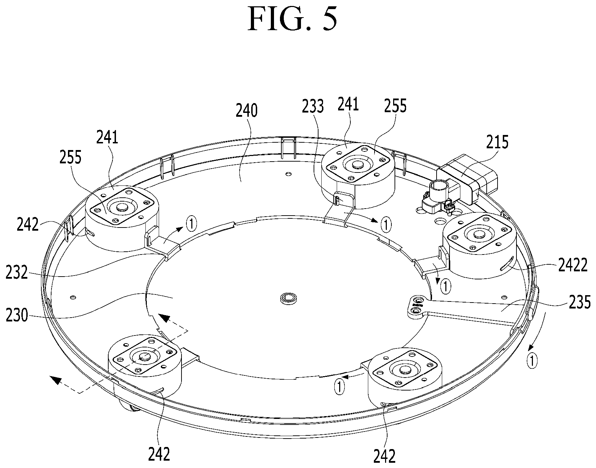

FIG. 5 is a perspective view illustrating the lower base case 240 and the rotation plate 230 according to an example of the stand base 200 of the present disclosure.

Referring to FIG. 5, a lower left side is a front side, and an upper right side is a rear side. A cable holder 214 for protecting a power cable extending to the rear side may be provided.

A plurality of wheel modules 250 is illustrated in FIG. 5. Since the stand pillar 160 and the display unit 151 are located in the rear direction, a distance between the wheels 253 in the rear direction may be shorter to maintain the support force.

The stand base 200 according to the present disclosure may include a rotation plate 230 located on the top surface of the lower base case 240. The rotation plate 230 may be rotatably coupled to the lower base case 240.

The lower base case 240 may guide the rotation plate 230 to rotate within a seating portion of the rotation plate 230 by adjusting the seating portion to be inserted downward. The lower base case 240 may include a hole 234 into which a central shaft 244 protruding from the center of the lower base case 240 is inserted so that the rotation plate 230 can rotate more stably.

The stand base 200 according to the present disclosure includes a rotation plate 230 located at the top surface of a lower base case 240. The rotation plate 230 may be coupled to the brake ring 260 seated inside the wheel housing 241, and may apply a force in a lateral direction so that the brake ring 260 can rotate within the wheel housing 241.

When the rotation plate 230 rotates, the plurality of brake rings 260 may rotate simultaneously within the wheel housing 241. A rotation lever 235, one side of which is coupled to the rotation plate 230 and the other side of which is exposed to the outside of the base case (210, 240) so that the user can manually rotate the rotation plate 230, may be included.

The rotation plate 230 may be rotatably coupled to the center of the top surface of the lower base case 240, and may include a plurality of connection portions 232 protruding toward the wheel housing 241. The connection portion 232 may be coupled to the brake ring 260 located inside the wheel housing 241, and the plurality of connection portions 232 may be coupled to each brake ring 260.

Referring to FIG. 4, the brake ring 260 may be formed in a cylindrical shape with a size corresponding to the inner diameter of the wheel housing 241, and may include a guide protrusion 262 protruding from the outer surface thereof. The guide protrusion 262 may be inserted into a guide slot 242 formed on the side surface of the wheel housing 241. The guide slot 242 limits the range of movement of the guide protrusion 262, and the guide protrusion 262 moves along the extension direction of the guide slot 242.

The guide slot 242 may be formed in a number corresponding to the number of guide protrusions 262. Referring to FIG. 4, an embodiment is illustrated in which three guide slots 242 are formed in one wheel housing 241 and three guide protrusions 262 are formed in one brake ring 260.

The guide protrusion 262 may further include an insertion slot 2421 extending to the guide slot 242 so that the guide protrusion 262 is inserted into the guide slot 242. The insertion slot 2421 is located at one side of the guide slot 242, and the guide slot 242 extends laterally.

The guide protrusion 262 may include a plurality of guide protrusions 262 as shown in FIG. 4, and one of the guide protrusions 262 may be formed longer and may be connected to the connection portion 232 of the rotation plate 230.

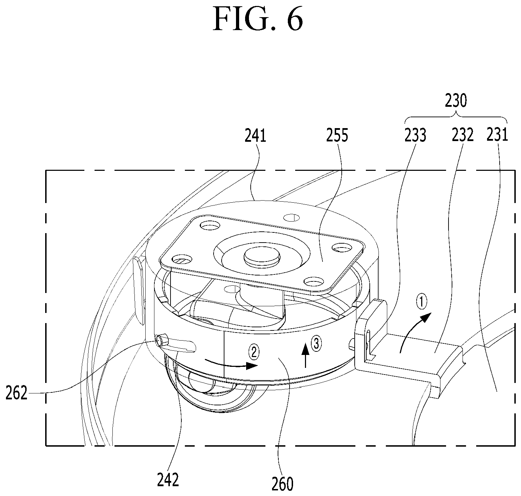

FIG. 6 is a diagram illustrating the movement of the brake ring 260 within the wheel housing 241 according to an example of the stand base 200 of the present disclosure. The end of the connection portion 232 extended from the rotation plate 230 may be bent in the vertical direction, and may include a vertical slot 233 extended in the vertical direction.

The brake ring 260 may be configured such that the guide protrusion 262 can be inserted into the vertical slot 233. When the rotation plate 230 rotates, a horizontal force is transmitted to the brake ring 260 through the guide protrusion 262, and the brake ring 260 rotates within the wheel housing 241.

The guide slot 242 formed in the wheel housing 241 is formed to be inclined. Thus, when the guide protrusion 262 moves in the horizontal direction, the guide slot 242 may also move in the vertical direction. Referring to FIG. 6, the guide slot 242 may be inclined to face upward in the right direction (counterclockwise). When the rotation plate 230 rotates clockwise (①), the brake ring 260 rotates counterclockwise (②), and since the extension direction of the guide slot 242 faces upward, the brake ring 260 moves upward (③) at the same time.

On the contrary, when the rotation plate 230 rotates counterclockwise, the brake ring 260 moves downward at the same time, which can restrict the rotation of the wheel 253.

When the brake ring 260 moves in the vertical direction, the guide protrusion 262 may move within the vertical slot 233 extending in the vertical direction. The vertical slot 233 may induce the horizontal movement of the guide protrusion 262, and the guide slot 242 may convert the horizontal movement of the guide protrusion 262 into vertical movement to induce the vertical movement of the brake ring 260.

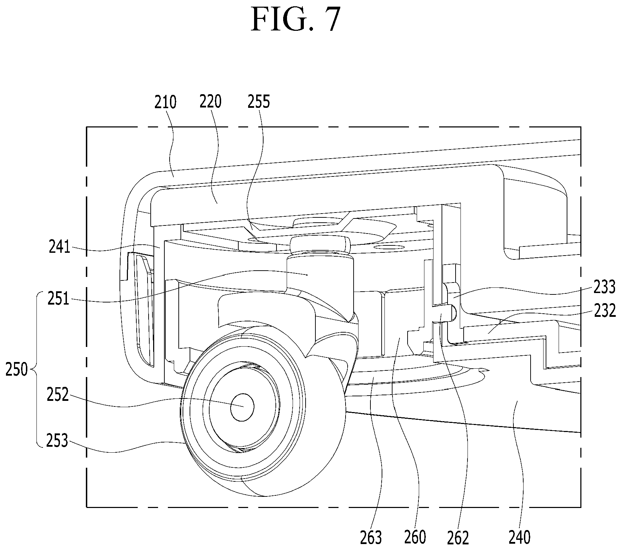

FIG. 7 is a cross-sectional view of the wheel module 250 according to an example of the stand base 200 of the present disclosure, which is a cross-sectional view of the structure taken along the A-A line of FIG. 2. The wheel module 250 may use a caster-shaped wheel 253 so that the traveling direction of the wheel module 250 can be freely changed. The wheel module 250 may be rotatably coupled to the upper portion of the wheel housing 241, and may rotate around a first shaft 251 extending in the vertical direction.

The wheel 253 rotates around a second shaft 252 that extends horizontally, and the second shaft 252 may be located at a position that is offset from another position where the first shaft 251 extends. Therefore, when the wheel module 250 rotates around the first shaft 251, the position of the wheel 253 may change within the wheel housing 241.

The wheel housing 241 may have a sufficient size (diameter) so that the wheel 253 does not come into contact with the wheel housing 241 when the wheel module 250 rotates, and the wheel 253 may be exposed to a lower portion of the wheel housing 241.

As shown in FIG. 7, when the wheel 253 comes in contact with the brake ring 260 located inside the wheel housing 241, the wheel 253 may not rotate due to friction with the brake ring 260, and the position of the stand base 200 may be fixed. The brake ring 260 may include a friction surface 263 that is inclined to correspond to the curved shape of the wheel 253 in order to secure a frictional area on the surface that comes into contact with the wheel 253.

The brake ring 260 may be formed in a ring shape, so that even if the wheel module 250 rotates and the position of the wheel 253 changes, the wheel 253 can come into contact with the frictional surface 263 of the brake ring 260. Since the position of the wheel 253 of the caster wheel 253 is not fixed, it is common to limit the rotation of the wheel 253 by using a stopper located at the wheel bracket 255.

However, in the brake ring 260 of the present disclosure, since the wheel module 250 is not exposed to the outside, it is difficult for the user to manually lock the stopper, and the process of locking or unlocking multiple wheels 253 one by one is cumbersome. Accordingly, the plurality of brake rings 260 may move downward to restrict the movement of the wheels 253 after the rotation plate 230 is rotated through the rotation lever 235.

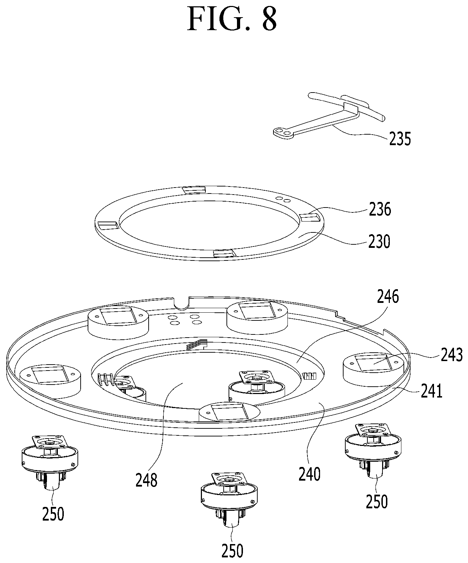

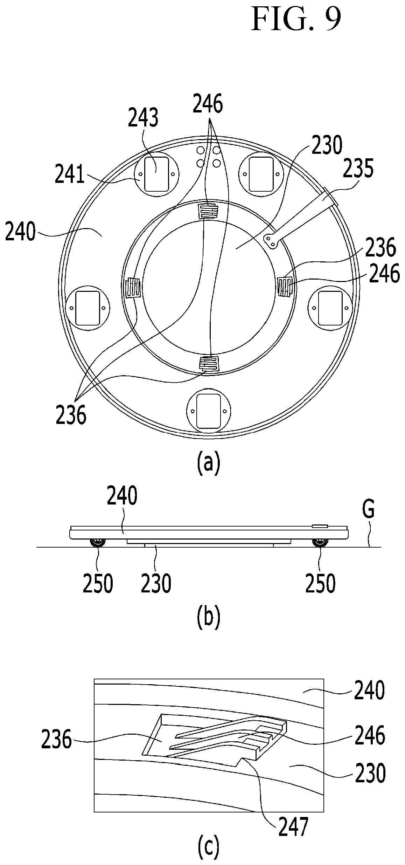

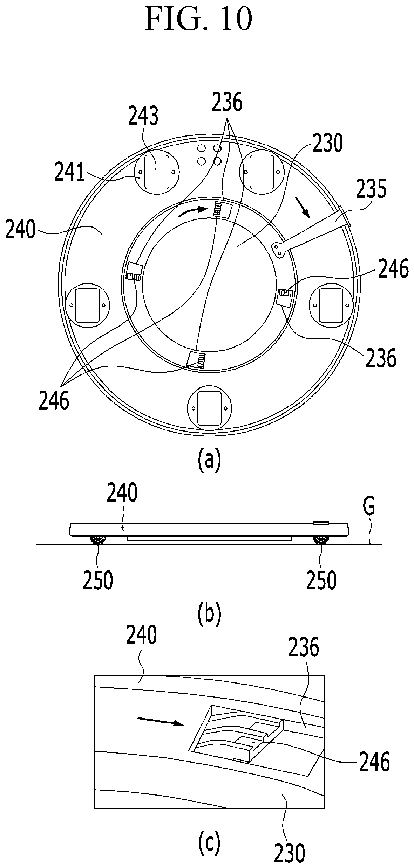

FIG. 8 is an exploded perspective view illustrating another example of the stand base 200 of the present disclosure. FIG. 9 is a diagram illustrating a locked state of the stand base 200 according to the embodiment of FIG. 8. FIG. 10 is a diagram illustrating an unlocked state of the stand base 200 according to the embodiment of FIG. 8.

The stand base 200 of this embodiment may fix the position of the stand base 200 in a different manner from the above-described embodiment. The lower base case 240 may include an opening 248 through which the rotation plate 230 is exposed, and the rotation plate 230 may be coupled to the lower base case 240 to cover the opening 248.

The rotation plate 230 may be fastened so as to be in contact with the inclined portion 246 formed on the lower base case 240. When the user rotates the rotation plate 230 through a rotation lever connected to one side of the rotation plate 230, the vertical height of the rotation plate 230 may change as the rotation plate 230 moves along the inclined portion 246 during rotation of the rotation plate 230.

In the present embodiment, the inclined portion 246 may be located along a circumference of the opening 248 of the lower base case 240, and the rotation plate 230 includes a hole 236 formed at a position corresponding to the inclined surface.

Referring to FIG. 9(a) and FIG. 9(c), the inclined surface may be exposed through the hole 236 formed in the rotation plate 230. At this time, as shown in FIG. 9(b), the rotation plate 230 may protrude downward through the opening 248 and may be in close contact with the lower base case 240. The protruding rotation plate 230 contacts the floor surface so that the movement of the rotation plate 230 by the wheel 253 is restricted.

A groove 247 may be formed at a lower portion of the upper side (highest portion) of the inclined portion 246. One end of the hole 236 of the rotation plate 230 may be fastened to the groove 247, and the vertical movement of the rotation plate 230 may be restricted. The rotation plate 230 may be maintained in a state in which the rotation plate 230 protrudes downward through the opening 248.

The user may change the position of the rotation plate 230 on the lower base case 240 by turning the rotation lever as shown in FIG. 10(a). One end of the hole 236 that was caught in the groove 247 moves laterally, and at the same time while the other end of the hole 236 moves along a slope of the inclined portion 246.

As shown in FIG. 10(c), the rotation plate 230 and the inclined portion 246 may overlap each other, and the rotation plate 230 may move upward to a height corresponding to the height of the inclined portion 246. As shown in FIG. 10(b), the rotation plate 230 may be inserted into the opening 248, and the wheel 253 may freely rotate and change the position of the stand base 200.

As described above, the stand base 200 according to the present disclosure can easily move using the wheel 253, and rotation of the wheel 253 can be restricted, thereby increasing stability of the stand base 200 placed at a desired position.

The stand base 200 can be simply fixed regardless of the direction of the wheel 253.

The above-described stand base 200 has been described as being applied to the display device 100, but can also be applied not only to small home appliances such as an air purifier, but also to furniture.

The detailed description above is not to be construed as limiting in any aspect and should be considered exemplary. The scope of this disclosure shall be determined by the appended claims.

## Claims

1. A movable stand base (200) comprising:
a base case (240);
a wheel housing (241) inserted from a lower portion of the base case (240);
a wheel module (250) placed in the wheel housing (241);
a rotation plate (230) rotatably coupled to the base case (240); and
a brake ring (260) that is located in the wheel housing (241), moves in a vertical direction while rotating during rotation of the rotation plate (230),
wherein, when the brake ring (260) moves downward, the brake ring (260) restricts rotation of a wheel (253) of the wheel module (250) by contacting the wheel.

2. The movable stand base (200) according to claim 1, wherein:
the wheel housing (241) is formed in a cylindrical shape; and
the wheel module (250) includes
a caster bracket (255) rotatably coupled to a center of an upper portion of the wheel housing (241); and
the wheel (253) coupled to the caster bracket (255) to rotate around a second shaft (252) perpendicular to a first shaft (251) located at a center of rotation of the caster bracket (255).

3. The movable stand base (200) according to claim 2, wherein the brake ring (260) includes:
a frictional surface (263) formed in a ring shape at a lower end of the stand base (200), and configured to include an inclined surface.

4. The movable stand base (200) according to claim 1, further comprising:
a guide slot (242) extending horizontally on a side surface of the wheel housing (241); and
a guide protrusion (262) protruding from an outer circumference of the brake ring (260) and inserted into the guide slot (242),
wherein
the guide slot (242) includes a slope obliquely inclined in a vertical direction; and
when the brake ring (260) rotates, a position of the brake ring (260) is changed vertically as the guide protrusion (262) moves along the guide slot (242).

5. The movable stand base (200) according to claim 4, wherein:
the guide slot (242) is implemented as a plurality of guide slots (242), and the guide protrusion (262) is implemented as a plurality of guide slots (242);
the rotation plate (230) further includes a vertical slot (233) into which one of the plurality of guide protrusions (262) is inserted so that the vertical slot (233) extends in a vertical direction; and
when the rotation plate (230) rotates, a position of the guide protrusion (262) on the vertical slot (233) is changed.

6. The movable stand base (200) according to claim 4, further comprising:
an insertion slot (2421) extending downward from an upper end of the guide slot (242).

7. The movable stand base (200) according to claim 1, further comprising:
a lever (235) extending from the rotation plate (230) and exposed on a side surface of the base case (240).

8. A movable stand base (200) comprising:
a base case (240) configured to include an opening (248) at a bottom surface thereof;
a wheel housing (241) inserted from a lower portion of the base case (240);
a wheel module (250) accommodated in the wheel housing (241);
an inclined portion (246) formed around the opening (248); and
a rotation plate (230) rotatably coupled to the base case (240) while overlapping the opening (248) of the base case (240) and the inclined portion (246),
wherein,
when the rotation plate (230) rotates, the rotation plate (230) moves along the inclined portion (246) and a height of the rotation plate (230) protruding downward from the opening (248) is changed.

9. The movable stand base (200) according to claim 8, further comprising:
a hole (236) formed at a position corresponding to the inclined portion (246) of the rotation plate (230); and
a groove located at a lower portion of an upper end of the inclined portion (246),
wherein
the inclined portion (246) is exposed through the hole, and when an end of the hole (236) is fastened to the groove, the rotation plate (230) protrudes downward from the opening (248); and
when the rotation plate (230) overlaps the inclined portion (246), the rotation plate (230) is inserted into the opening (248).

10. A display device (100) comprising:
a main body (100');
a stand pillar (160) configured to extend downward from the main body (100'); and
the movable stand base of one of claim 1 to 9, located at a lower portion of the stand pillar (160).

## Patentansprüche

1. Beweglicher Standfuß (200), umfassend:
ein Basisgehäuse (240);
ein Radgehäuse (241), das von einem unteren Abschnitt des Basisgehäuses (240) eingesetzt ist;
ein Radmodul (250), das in dem Radgehäuse (241) platziert ist;
eine Drehplatte (230), die drehbar mit dem Basisgehäuse (240) gekoppelt ist; und
einen Bremsring (260), der in dem Radgehäuse (241) angeordnet ist und sich in einer vertikalen Richtung bewegt, während er sich während der Drehung der Drehplatte (230) dreht,
wobei, wenn sich der Bremsring (260) nach unten bewegt, der Bremsring (260) eine Drehung eines Rads (253) des Radmoduls (250) durch Kontaktieren des Rads beschränkt.

2. Beweglicher Standfuß (200) nach Anspruch 1, wobei:
das Radgehäuse (241) in einer zylindrischen Form ausgebildet ist; und
das Radmodul (250) aufweist
eine Rollenhalterung (255), die drehbar mit einer Mitte eines oberen Abschnitts des Radgehäuses (241) gekoppelt ist; und
das Rad (253), das mit der Rollenhalterung (255) gekoppelt ist, um sich um eine zweite Achse (252) zu drehen, die senkrecht zu einer ersten Achse (251) ist, die sich an einer Drehmitte der Rollenhalterung (255) befindet.

3. Beweglicher Standfuß (200) nach Anspruch 2, wobei der Bremsring (260) aufweist:
eine Reibfläche (263), die in einer Ringform an einem unteren Ende des Standfußes (200) ausgebildet ist und dazu eingerichtet ist, eine geneigte Fläche zu aufzuweisen.

4. Beweglicher Standfuß (200) nach Anspruch 1, ferner aufweisend:
einen Führungsschlitz (242), der sich horizontal an einer Seitenfläche des Radgehäuses (241) erstreckt; und
einen Führungsvorsprung (262), der von einem Außenumfang des Bremsrings (260) vorsteht und in den Führungsschlitz (242) eingesetzt ist, wobei
der Führungsschlitz (242) eine Schrägung aufweist, die in einer vertikalen Richtung schräg geneigt ist; und
wenn sich der Bremsring (260) dreht, eine Position des Bremsrings (260) vertikal geändert wird, während sich der Führungsvorsprung (262) entlang des Führungsschlitzes (242) bewegt.

5. Beweglicher Standfuß (200) nach Anspruch 4, wobei:
der Führungsschlitz (242) als eine Mehrzahl von Führungsschlitzen (242) umgesetzt ist, und der Führungsvorsprung (262) als eine Mehrzahl von Führungsschlitzen (242) umgesetzt ist;
die Drehplatte (230) ferner einen vertikalen Schlitz (233) aufweist, in den einer der Mehrzahl von Führungsvorsprüngen (262) eingesetzt ist, sodass sich der vertikale Schlitz (233) in einer vertikalen Richtung erstreckt; und
wenn sich die Drehplatte (230) dreht, eine Position des Führungsvorsprungs (262) an dem vertikalen Schlitz (233) geändert wird.

6. Beweglicher Standfuß (200) nach Anspruch 4, ferner aufweisend:
einen Einführschlitz (2421), der sich von einem oberen Ende des Führungsschlitzes (242) nach unten erstreckt.

7. Beweglicher Standfuß (200) nach Anspruch 1, ferner aufweisend:
einen Hebel (235), der sich von der Drehplatte (230) erstreckt und an einer Seitenfläche des Basisgehäuses (240) freiliegt.

8. Beweglicher Standfuß (200), aufweisend:
ein Basisgehäuse (240), das dazu eingerichtet ist, eine Öffnung (248) an dessen Bodenfläche aufzuweisen;
ein Radgehäuse (241), das von einem unteren Abschnitt des Basisgehäuses (240) eingesetzt ist;
ein Radmodul (250), das in dem Radgehäuse (241) aufgenommen ist;
einen geneigten Abschnitt (246), der um die Öffnung (248) herum ausgebildet ist; und
eine Drehplatte (230), die drehbar mit dem Basisgehäuse (240) gekoppelt ist, während sie die Öffnung (248) des Basisgehäuses (240) und den geneigten Abschnitt (246) überlappt,
wobei,
wenn sich die Drehplatte (230) dreht, sich die Drehplatte (230) entlang des geneigten Abschnitts (246) bewegt und eine Höhe der Drehplatte (230), die von der Öffnung (248) nach unten vorsteht, geändert wird.

9. Beweglicher Standfuß (200) nach Anspruch 8, ferner aufweisend:
ein Loch (236), das an einer Position ausgebildet ist, die dem geneigten Abschnitt (246) der Drehplatte (230) entspricht; und
eine Nut, die an einem unteren Abschnitt eines oberen Endes des geneigten Abschnitts (246) angeordnet ist, wobei
der geneigte Abschnitt (246) durch das Loch freiliegt, und wenn ein Ende des Lochs (236) an der Nut befestigt ist, die Drehplatte (230) von der Öffnung (248) nach unten vorsteht; und
wenn die Drehplatte (230) den geneigten Abschnitt (246) überlappt, die Drehplatte (230) in die Öffnung (248) eingesetzt ist.

10. Anzeigevorrichtung (100), umfassend:
einen Hauptkörper (100');
eine Ständersäule (160), die dazu eingerichtet ist, sich von dem Hauptkörper (100') nach unten zu erstrecken; und
den beweglichen Standfuß nach einem der Ansprüche 1 bis 9, der an einem unteren Abschnitt der Ständersäule (160) angeordnet ist.

## Revendications

1. Base de support mobile (200) comprenant :
un boîtier de base (240) ;
un logement de roue (241) inséré depuis une partie inférieure du boîtier de base (240) ;
un module de roue (250) placé dans le logement de roue (241) ;
une plaque de rotation (230) couplée de manière rotative au boîtier de base (240) ; et
un anneau de freinage (260) qui est situé dans le logement de roue (241), se déplace dans une direction verticale tout en tournant pendant la rotation de la plaque de rotation (230),
dans laquelle, lorsque l'anneau de freinage (260) se déplace vers le bas, l'anneau de freinage (260) restreint la rotation d'une roue (253) du module de roue (250) en entrant en contact avec la roue.

2. Base de support mobile (200) selon la revendication 1, dans laquelle :
le logement de roue (241) est formé selon une forme cylindrique ; et
le module de roue (250) comprend
un support de roulette (255) couplé de manière rotative à un centre d'une partie supérieure du logement de roue (241) ; et
la roue (253) couplée au support de roulette (255) pour tourner autour d'un second axe (252) perpendiculaire à un premier axe (251) situé à un centre de rotation du support de roulette (255).

3. Base de support mobile (200) selon la revendication 2, dans laquelle l'anneau de freinage (260) comprend :
une surface de friction (263) formée selon une forme annulaire à une extrémité inférieure de la base de support (200), et configurée pour comprendre une surface inclinée.

4. Base de support mobile (200) selon la revendication 1, comprenant en outre :
une fente de guidage (242) s'étendant horizontalement sur une surface latérale du logement de roue (241) ; et
une saillie de guidage (262) faisant saillie depuis une circonférence extérieure de l'anneau de freinage (260) et insérée dans la fente de guidage (242), dans laquelle
la fente de guidage (242) comprend une pente inclinée obliquement dans une direction verticale ; et lorsque l'anneau de freinage (260) tourne, une position de l'anneau de freinage (260) est modifiée verticalement à mesure que la saillie de guidage (262) se déplace le long de la fente de guidage (242).

5. Base de support mobile (200) selon la revendication 4, dans laquelle :
la fente de guidage (242) est mise en œuvre sous la forme d'une pluralité de fentes de guidage (242), et la saillie de guidage (262) est mise en œuvre sous la forme d'une pluralité de fentes de guidage (242) ;
la plaque de rotation (230) comprend en outre une fente verticale (233) dans laquelle l'une de la pluralité de saillies de guidage (262) est insérée de sorte que la fente verticale (233) s'étend dans une direction verticale ; et
lorsque la plaque de rotation (230) tourne, une position de la saillie de guidage (262) sur la fente verticale (233) est modifiée.

6. Base de support mobile (200) selon la revendication 4, comprenant en outre :
une fente d'insertion (2421) s'étendant vers le bas depuis une extrémité supérieure de la fente de guidage (242).

7. Base de support mobile (200) selon la revendication 1, comprenant en outre :
un levier (235) s'étendant depuis la plaque de rotation (230) et exposé sur une surface latérale du boîtier de base (240).

8. Base de support mobile (200) comprenant :
un boîtier de base (240) configuré pour comprendre une ouverture (248) sur une surface inférieure de celui-ci ;
un logement de roue (241) inséré depuis une partie inférieure du boîtier de base (240) ;
un module de roue (250) logé dans le logement de roue (241) ;
une partie inclinée (246) formée autour de l'ouverture (248) ; et
une plaque de rotation (230) couplée de manière rotative au boîtier de base (240) tout en chevauchant l'ouverture (248) du boîtier de base (240) et la partie inclinée (246),
dans laquelle,
lorsque la plaque de rotation (230) tourne, la plaque de rotation (230) se déplace le long de la partie inclinée (246) et une hauteur de la plaque de rotation (230) faisant saillie vers le bas depuis l'ouverture (248) est modifiée.

9. Base de support mobile (200) selon la revendication 8, comprenant en outre :
un trou (236) formé à une position correspondant à la partie inclinée (246) de la plaque de rotation (230) ; et
une rainure située à une partie inférieure d'une extrémité supérieure de la partie inclinée (246), dans laquelle
la partie inclinée (246) est exposée à travers le trou, et lorsqu'une extrémité du trou (236) est fixée à la rainure, la plaque de rotation (230) fait saillie vers le bas depuis l'ouverture (248) ; et
lorsque la plaque de rotation (230) chevauche la partie inclinée (246), la plaque de rotation (230) est insérée dans l'ouverture (248).

10. Dispositif d'affichage (100) comprenant :
un corps principal (100') ;
une colonne de support (160) configurée pour s'étendre vers le bas depuis le corps principal (100') ; et
la base de support mobile selon l'une des revendications 1 à 9, située à une partie inférieure de la colonne de support (160).
